# EUROPEAN PATENT APPLICATION

(11) **EP 4 817 793 A1**
(43) Date of publication of application: **07.10.2026**
(21) Application number: 24897168.1
(22) Date of filing: 25.10.2024
(51) Int. Cl.: B24B 21/20, B24B 49/10, B24B 49/16, H01L 21/304

(54) **SUBSTRATE PROCESSING APPARATUS AND SUBSTRATE PROCESSING METHOD**

(30) Priority: 01.12.2023 JP 2023203893
(71) Applicant: EBARA CORPORATION, Ota-ku, Tokyo 144-8510 (JP)
(72) Inventor: YAZAWA, Akihiro, Tokyo 144-8510 (JP); SUZUKI, Tatsuya, Tokyo 144-8510 (JP); TAKENAKA, Hiroyuki, Tokyo 144-8510 (JP)
(74) Representative: Wagner & Geyer
(86) International application number: PCT/JP2024/038176
(87) International publication number: WO 2025/115479

(57) **Abstract**

The present invention relates to a substrate processing apparatus for processing a substrate, such as a wafer. The substrate processing apparatus (1) includes a substrate holder (5), a processing head (10), a tape take-up reel (22), a take-up reel rotating mechanism (32), a tape outer diameter acquisition mechanism (70) configured to acquire an outer diameter of a roll (36) of a processing tape (2) taken up on the tape take-up reel (22), a rotary torque calculating section (72) configured to calculate a rotary torque required for taking up the processing tape (2) on tape take-up reel (22) with a predetermined tape tension based on the outer diameter, and an operation controller (60) configured to control an operation of the take-up reel rotating mechanism (32). The operation controller (60) is configured to instruct the take-up reel rotating mechanism (32) to rotate the tape take-up reel (22) with the calculated rotary torque.

## Description

### Technical Field

The present invention relates to a substrate processing apparatus and a substrate processing method for processing a substrate, such as a wafer.

### Background Art

Management of a surface condition of a substrate has recently attracted attention from the viewpoint of an increase in yield in manufacturing of semiconductor devices. In a semiconductor device manufacturing process, films of various materials are formed on a silicon wafer. Therefore, an unnecessary film or surface roughness may be formed on a periphery of the substrate. These days it is a common practice to transport a substrate by holding only a periphery of the substrate with arms. With such a background, an unnecessary film, remaining on the periphery of the substrate, may peel off during various processes and may adhere to devices formed on the substrate, resulting in reducing yield. Thus, in order to remove the unnecessary film from the periphery of the substrate, polishing of the periphery of the substrate is performed using a polishing apparatus.

This type of polishing apparatus is configured to polish the periphery of the substrate by bringing a polishing tape into sliding contact with the periphery of the substrate. More specifically, the polishing apparatus polishes the periphery of the substrate by pressing the polishing tape against the periphery of the substrate with a polishing head while holding and rotating the substrate with a substrate holder. During polishing of the substrate, the polishing tape is fed from a tape feeding reel to a tape take-up reel via the polishing head by a processing-tape feeding mechanism.

### Citation List

### Patent Literature

Patent document 1: Japanese laid-open patent publication No. 2008-87136
Patent document 2: Japanese laid-open patent publication No. 2018-46189

### Summary of Invention

### Technical Problem

An outer diameter of a roll of the polishing tape taken up on the tape take-up reel increases with an amount of use of the polishing tape. When a polishing tape with a large thickness or a polishing tape with a long overall length is used, a difference in the outer diameter of the roll between a start of winding and an end of winding of the polishing tape becomes significantly large.

Generally, since the tape take-up reel is rotated with a constant rotary torque, a tape tension for taking up the polishing tape is inversely proportional to the outer diameter of the roll of the taken-up polishing tape. Therefore, as the outer diameter of the roll of the polishing tape increases, the tape tension decreases, and the tape take-up reel may not be able to properly take up the polishing tape. In order to properly take up the polishing tape when the outer diameter of the roll of the polishing tape becomes large, it is considered to rotate the tape take-up reel with a large constant rotary torque. However, with a large rotary torque, an excessive tape tension is applied particularly at the start of winding the polishing tape, so that a load is applied to the polishing tape. As a result, problems, such as a breakage of the polishing tape and an influence on an advancing speed of the polishing tape, may occur.

Thus, the present invention provides a substrate processing apparatus and a substrate processing method capable of taking up a processing tape on a tape take-up reel with an appropriate tape tension even when an outer diameter of a roll of the processing tape changes significantly.

### Solution to Problem

In an embodiment, there is provided a substrate processing apparatus comprising: a substrate holder configured to hold and rotate a substrate; a processing head configured to press a processing tape against the substrate to process the substrate; a tape take-up reel configured to take up the processing tape that has been used in processing of the substrate; a take-up reel rotating mechanism configured to rotate the tape take-up reel; a tape outer diameter acquisition mechanism configured to acquire an outer diameter of a roll of the processing tape taken up on the tape take-up reel; a rotary torque calculating section configured to calculate a rotary torque required for taking up the processing tape on the tape take-up reel with a predetermined tape tension based on the acquired outer diameter; and an operation controller configured to control an operation of the take-up reel rotating mechanism, wherein the operation controller is configured to instruct the take-up reel rotating mechanism to rotate the tape take-up reel with the calculated rotary torque.

In an embodiment, the tape outer diameter acquisition mechanism comprises an outer diameter measuring device configured to measure the outer diameter of the roll, and the rotary torque calculating section is configured to calculate the rotary torque based on the measured outer diameter.

In an embodiment, the tape outer diameter acquisition mechanism includes: a thickness measuring device configured to measure a thickness of the processing tape; and an outer diameter calculating section configured to calculate the outer diameter of the roll based on the measured thickness of the processing tape and an amount of use of the processing tape, and the rotary torque calculating section is configured to calculate the rotary torque based on the calculated outer diameter.

In an embodiment, the tape outer diameter acquisition mechanism includes an outer diameter calculating section configured to calculate the outer diameter of the roll based on a thickness of the processing tape that has been input via an input device and an amount of use of the processing tape, and the rotary torque calculating section is configured to calculate the rotary torque based on the calculated outer diameter.

In an embodiment, the processing tape comprises a polishing tape having a polishing surface, and the processing head comprises a polishing head configured to press the polishing surface against the substrate to polish the substrate.

In an embodiment, there is provided a substrate processing method comprising: holding and rotating a substrate, and pressing a processing tape against the substrate with a processing head to process the substrate; rotating a tape take-up reel by a take-up reel rotating mechanism to take up the processing tape that has been used in processing of the substrate onto the tape take-up reel; acquiring an outer diameter of a roll of the processing tape taken up on the tape take-up reel; calculating a rotary torque required for taking up the processing tape on the tape take-up reel with a predetermined tape tension based on the acquired outer diameter; and taking up the processing tape onto the tape take-up reel by rotating the tape take-up reel with the calculated rotary torque by the take-up reel rotating mechanism.

In an embodiment, acquiring the outer diameter of the roll comprises measuring the outer diameter of the roll by an outer diameter measuring device, and calculating the rotary torque comprises calculating the rotary torque based on the measured outer diameter.

In an embodiment, acquiring the outer diameter of the roll comprises measuring a thickness of the processing tape by a thickness measuring device, and calculating the outer diameter of the roll based on the measured thickness of the processing tape and an amount of use of the processing tape, and calculating the rotary torque comprises calculating the rotary torque based on the calculated outer diameter.

In an embodiment, acquiring the outer diameter of the roll comprises calculating the outer diameter of the roll based on a thickness of the processing tape that has been input via an input device and an amount of use of the processing tape, and calculating the rotary torque comprises calculating the rotary torque based on the calculated outer diameter.

In an embodiment, processing the substrate comprises pressing a polishing surface of a polishing tape against the substrate with a polishing head to polish the substrate.

### Advantageous Effects of Invention

The substrate processing apparatus and the substrate processing method can acquire the outer diameter of the roll of the processing tape taken up on the tape take-up reel, and can calculate the rotary torque for taking up the processing tape with the predetermined appropriate tape tension based on the acquired outer diameter of the roll. As a result, the processing tape can be taken up on the tape take-up reel with the appropriate tape tension even when the outer diameter of the roll of the processing tape changes significantly.

### Brief Description of Drawings

[FIG. 1] FIG. 1 is a side view showing an embodiment of a substrate processing apparatus;
[FIG. 2] FIG. 2 is a plan view of the substrate processing apparatus shown in FIG. 1;
[FIG. 3] FIG. 3 is a schematic diagram showing a processing-tape feeding mechanism and an outer diameter measuring device as a tape outer diameter acquisition mechanism according to the present embodiment;
[FIG. 4] FIG. 4 is a schematic diagram showing a manner in which a processing tape is taken up onto a tape take-up reel;
[FIG. 5] FIG. 5 is a schematic diagram showing another embodiment of the tape outer diameter acquisition mechanism;
[FIG. 6] FIG. 6 is a diagram illustrating a method of calculating an outer diameter of a roll based on a measured thickness of the processing tape; and
[FIG. 7] FIG. 7 is a schematic diagram showing still another embodiment of the tape outer diameter acquisition mechanism.

### Description of Embodiments

Embodiments will now be described with reference to the drawings.

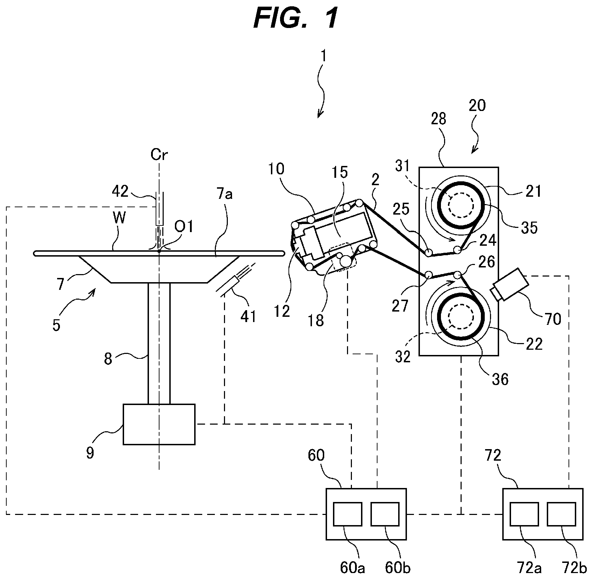

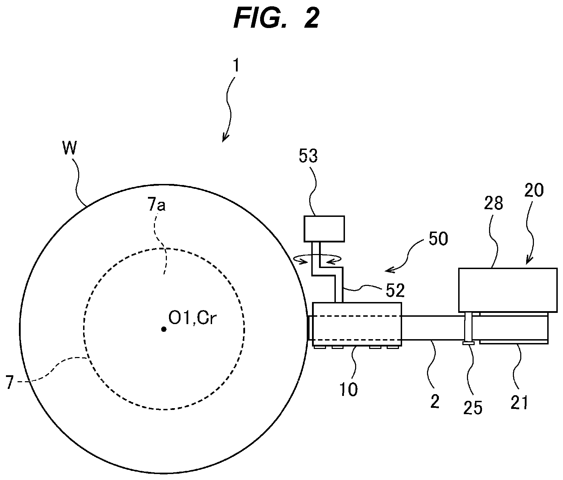

FIG. 1 is a side view showing an embodiment of a substrate processing apparatus 1, and FIG. 2 is a plan view of the substrate processing apparatus 1 shown in FIG. 1. The substrate processing apparatus 1 of this embodiment is an apparatus for processing a periphery of a substrate W, such as a wafer. In this specification, the periphery of the substrate W refers to a region including at least one of a bevel portion, a top-edge portion, and a bottom-edge portion of the substrate W. In one embodiment, the substrate processing apparatus 1 may be an apparatus for processing a notch of the substrate W or an apparatus for processing a back surface of the substrate W.

As shown in FIG. 1, the substrate processing apparatus 1 includes a substrate holder 5 configured to hold and rotate the substrate W, a processing head 10 configured to press a processing tape 2 against the substrate W to process the substrate W, a processing-tape feeding mechanism 20 configured to feed the processing tape 2 to the processing head 10 and collect the processing tape 2 from the processing head 10, a lower supply nozzle 41, and an upper supply nozzle 42.

Examples of the substrate processing apparatus 1 include a polishing apparatus for polishing the substrate W, and a cleaning apparatus for cleaning the substrate W. When the substrate processing apparatus 1 is the polishing apparatus, the processing tape 2 is a polishing tape having a polishing surface to which abrasive grains are fixed, and the processing head 10 is a polishing head configured to press the polishing tape against the substrate W to polish the substrate W. When the substrate processing apparatus 1 is the cleaning apparatus, the processing tape 2 is a cleaning tape made of non-woven fabric, woven fabric, knitted fabric, or the like, and the processing head 10 is a cleaning head configured to press the cleaning tape against the substrate W to clean the substrate W.

In this embodiment, the substrate processing apparatus 1 includes one processing head 10, while in one embodiment, the substrate processing apparatus 1 may include two or more processing heads.

The substrate holder 5 includes a holding stage 7 configured to hold the substrate W by vacuum suction, a shaft 8 coupled to a center portion of the holding stage 7, and a holding-stage driving mechanism 9 configured to rotate and vertically move the holding stage 7. The holding-stage driving mechanism 9 is configured to rotate the holding stage 7 about a rotation axis Cr, and is configured to move the holding stage 7 in a vertical direction along the rotation axis Cr. An axis passing through a center O1 of the substrate W coincides with the rotation axis Cr of the holding stage 7.

The processing-tape feeding mechanism 20 includes a tape feeding reel 21 configured to feed the processing tape 2 to the processing head 10, a tape take-up reel 22 configured to take up the processing tape 2 that has been used in processing of the substrate W, and a plurality of guide rollers 24, 25, 26, and 27. The tape feeding reel 21, the tape take-up reel 22, and the plurality of guide rollers 24, 25, 26, and 27 are fixed to a reel base 28.

A roll 35 of the processing tape 2 before being used in processing of the substrate W is mounted on the tape feeding reel 21. The processing tape 2 is fed from the tape feeding reel 21 to the tape take-up reel 22 via the processing head 10. An advancing direction of the processing tape 2 is guided by the guide rollers 24, 25, 26, and 27. The processing tape 2 that has been used in processing of the substrate W is taken up onto the tape take-up reel 22 to form a roll 36.

The processing-tape feeding mechanism 20 further includes a feeding-reel rotating mechanism 31 and a take-up reel rotating mechanism 32. The feeding-reel rotating mechanism 31 is coupled to the tape feeding reel 21, and the take-up reel rotating mechanism 32 is coupled to the tape take-up reel 22. The feeding-reel rotating mechanism 31 is configured to apply a rotary torque to the tape feeding reel 21 to rotate the tape feeding reel 21. The take-up reel rotating mechanism 32 is configured to apply a rotary torque to the tape take-up reel 22 to rotate the tape take-up reel 22.

In one embodiment, each of the feeding-reel rotating mechanism 31 and the take-up reel rotating mechanism 32 is a combination of a motor and a motor driver configured to apply a voltage to the motor. A rotary torque of the motor can be changed by the voltage applied from the motor driver to the motor.

The feeding-reel rotating mechanism 31 and the take-up reel rotating mechanism 32 rotate the tape feeding reel 21 and the tape take-up reel 22 in opposite directions, as indicated by arrows in FIG. 1, so that a predetermined tension can be applied to the processing tape 2. The processing tape 2 is fed at a predetermined speed by a tape advancing mechanism 18 provided in the processing head 10.

The lower supply nozzle 41 is configured to supply liquid onto a lower surface of the substrate W. The upper supply nozzle 42 is configured to supply liquid onto an upper surface of the substrate W. An example of the liquid supplied to the substrate W is pure water. During processing of the substrate W, the liquid is supplied from the lower supply nozzle 41 onto the lower surface of the substrate W, and the liquid is supplied from the upper supply nozzle 42 onto the upper surface of the substrate W.

The processing head 10 includes a pressing member 12 configured to press the processing tape 2 against the periphery of the substrate W, and an air cylinder (actuator) 15 configured to move the pressing member 12 toward the periphery of the substrate W. A pressing force on the processing tape 2 against the substrate W is regulated by controlling a pressure of air supplied to the air cylinder 15. The pressing member 12 is arranged at a back surface side of the processing tape 2. An electric actuator may be used instead of the air cylinder 15 as the actuator configured to move the pressing member 12 toward the periphery of the substrate W.

As shown in FIG. 2, the substrate processing apparatus 1 further includes a tilting mechanism 50 configured to tilt the processing head 10 with respect to a substrate holding surface 7a of the holding stage 7. The tilting mechanism 50 is coupled to the processing head 10. The tilting mechanism 50 includes a tilting arm 52 coupled to the processing head 10, and an arm rotating device 53 configured to rotate the tilting arm 52. One end of the tilting arm 52 is located at the same height as that of the substrate holding surface 7a of the holding stage 7, and is coupled to the arm rotating device 53. The other end of the tilting arm 52 is coupled to the processing head 10.

When the arm rotating device 53 rotates the tilting arm 52, the tilting mechanism 50 can tilt the entire processing head 10 with respect to the substrate W on the substrate holding surface 7a of the holding stage 7 at a predetermined tilting speed. Further, the tilting mechanism 50 is configured to maintain a predetermined angle of inclination of the processing head 10. The specific configuration of the tilting mechanism 50 is not limited to this embodiment as long as the processing head 10 can be tilted with respect to the substrate holding surface 7a of the holding stage 7 and the substrate W.

The holding-stage driving mechanism 9 of the substrate holder 5, the air cylinder 15 and the tape advancing mechanism 18 of the processing head 10, the feeding-reel rotating mechanism 31 and the take-up reel rotating mechanism 32 of the processing-tape feeding mechanism 20, the lower supply nozzle 41, the upper supply nozzle 42, and the arm rotating device 53 of the tilting mechanism 50 are electrically coupled to an operation controller 60. Operations of the holding-stage driving mechanism 9 of the substrate holder 5, the air cylinder 15 and the tape advancing mechanism 18 of the processing head 10, the feeding-reel rotating mechanism 31 and the take-up reel rotating mechanism 32 of the processing-tape feeding mechanism 20, the lower supply nozzle 41, the upper supply nozzle 42, and the arm rotating device 53 of the tilting mechanism 50 are controlled by the operation controller 60.

The operation controller 60 includes at least one computer. The operation controller 60 includes a memory 60a storing programs and the like therein, and a processor 60b configured to perform arithmetic operations according to instructions contained in the programs. The memory 60a includes a main memory, such as a random access memory (RAM), and an auxiliary memory, such as a hard disk drive (HDD) or a solid state drive (SSD). Examples of the processor 60b include a CPU (central processing unit) and a GPU (graphics processing unit). However, the specific configuration of the operation controller 60 is not limited to these examples.

Processing of the periphery of the substrate W is performed as follows. The substrate W to be processed is placed on the substrate holding surface 7a of the holding stage 7 of the substrate holder 5 and held by vacuum suction. The substrate holder 5 lowers the substrate W to a processing position and rotates the holding stage 7. Further, the liquid is supplied from the lower supply nozzle 41 and the upper supply nozzle 42. Next, the air cylinder 15 of the processing head 10 is driven to press the processing tape 2 against the periphery of the substrate W with the pressing member 12, so that the periphery of the substrate W is processed. During the processing of the substrate W, the tilting mechanism 50 tilts the processing head 10 with respect to the substrate holding surface 7a of the holding stage 7 at the predetermined tilting speed. Alternatively, the tilting mechanism 50 maintains the predetermined angle of inclination of the processing head 10 with respect to the substrate holding surface 7a of the holding stage 7.

The substrate processing apparatus 1 further includes a tape outer diameter acquisition mechanism configured to acquire an outer diameter of the roll 36 of the processing tape 2 taken up on the tape take-up reel 22. As shown in FIG. 1, in this embodiment, the tape outer diameter acquisition mechanism is an outer diameter measuring device 70 configured to measure the outer diameter of the roll 36 of the processing tape 2 taken up on the tape take-up reel 22.

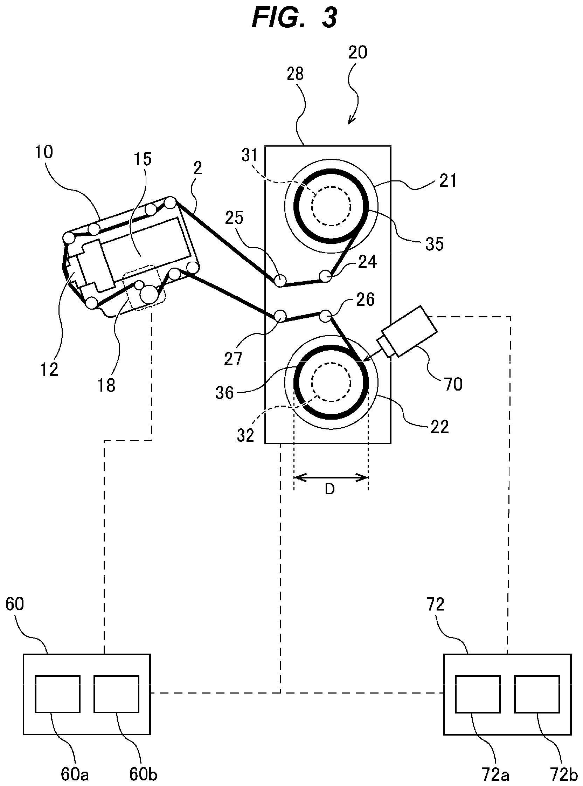

FIG. 3 is a schematic diagram showing the processing-tape feeding mechanism 20 and the outer diameter measuring device 70 as the tape outer diameter acquisition mechanism according to the present embodiment. As shown in FIG. 3, the outer diameter measuring device 70 as the tape outer diameter acquisition mechanism is disposed radially outwardly of the roll 36 of the processing tape 2 taken up on the tape take-up reel 22. The outer diameter measuring device 70 is configured to measure the outer diameter D of the roll 36 based on a distance to a surface of the roll 36 of the processing tape 2. In one embodiment, the outer diameter measuring device 70 is constituted of a displacement sensor, which is a non-contact type or a contact type, and a signal processing section configured to detect the outer diameter D of the roll 36 based on a signal output by the displacement sensor.

The specific configuration of the outer diameter measuring device 70 is not limited to the above-described embodiment as long as the outer diameter of the roll 36 of the processing tape 2 taken up on the tape take-up reel 22 can be measured. For example, the outer diameter measuring device 70 may include an image generating device configured to generate an image of the roll 36 of the processing tape 2, and may be configured to detect the outer diameter D of the roll 36 based on the generated image of the roll 36 of the processing tape 2.

The substrate processing apparatus 1 further includes a rotary torque calculating section 72 configured to calculate a rotary torque required for taking up the processing tape 2 on the tape take-up reel 22 with a predetermined tape tension based on the outer diameter D of the roll 36 of the processing tape 2 acquired by the tape outer diameter acquisition mechanism. In this embodiment, the rotary torque calculating section 72 is configured to calculate the rotary torque required for taking up the processing tape 2 on the tape take-up reel 22 with the predetermined tape tension based on the outer diameter D of the roll 36 of the processing tape 2 measured by the outer diameter measuring device 70.

The rotary torque calculating section 72 is electrically coupled to the tape outer diameter acquisition mechanism, and the outer diameter D of the roll 36 of the processing tape 2 acquired by the tape outer diameter acquisition mechanism is transmitted to the rotary torque calculating section 72. In this embodiment, the rotary torque calculating section 72 is electrically coupled to the outer diameter measuring device 70, and the outer diameter D of the roll 36 of the processing tape 2 measured by the outer diameter measuring device 70 is transmitted to the rotary torque calculating section 72.

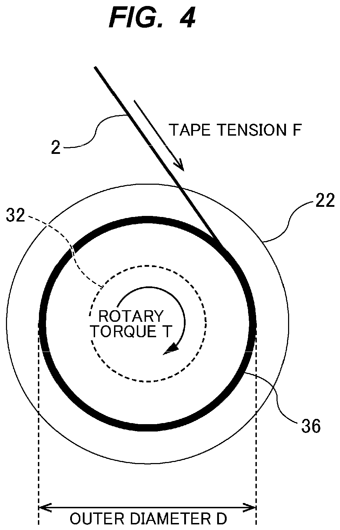

FIG. 4 is a schematic diagram showing a manner in which the processing tape 2 is taken up onto the tape take-up reel 22. The take-up reel rotating mechanism 32 rotates the tape take-up reel 22 with a rotary torque T, so that the processing tape 2 is taken up onto the tape take-up reel 22 with a tape tension F. A relationship between the rotary torque T, the tape tension F, and the outer diameter D of the roll 36 of the processing tape 2 taken up on the tape take-up reel 22 is represented by the following formula (1). $F = 2 T / D$ (1)

The rotary torque calculating section 72 calculates the rotary torque T from the outer diameter D of the roll 36 of the processing tape 2 measured by the outer diameter measuring device 70 and the predetermined tape tension F using the formula (1). The tape tension F is predetermined to an appropriate value for properly taking up the processing tape 2 onto the tape take-up reel 22. During the processing of the substrate W, the tape tension F is constant. In one embodiment, the tape tension F is constant from when use of the processing tape 2 is started until the entire processing tape 2 is taken up on the tape take-up reel 22.

The rotary torque calculating section 72 is electrically coupled to the operation controller 60, and the rotary torque T calculated by the rotary torque calculating section 72 is transmitted to the operation controller 60. The operation controller 60 is configured to instruct the take-up reel rotating mechanism 32 to rotate the tape take-up reel 22 with the calculated rotary torque T.

The rotary torque calculating section 72 includes at least one computer. The rotary torque calculating section 72 includes a memory 72a storing programs and the like therein, and a processor 72b configured to perform arithmetic operations according to instructions contained in the programs. The memory 72a includes a main memory, such as a random access memory (RAM), and an auxiliary memory, such as a hard disk drive (HDD) or a solid state drive (SSD). Examples of the processor 72b include a CPU (central processing unit) and a GPU (graphics processing unit). However, the specific configuration of the rotary torque calculating section 72 is not limited to these examples. In one embodiment, the rotary torque calculating section 72 may be configured integrally with the operation controller 60.

Acquisition of the outer diameter D of the roll 36 of the processing tape 2 by the tape outer diameter acquisition mechanism (in this embodiment, measurement of the outer diameter D of the roll 36 of the processing tape 2 by the outer diameter measuring device 70) and calculation of the rotary torque T by the rotary torque calculating section 72 may be performed during the processing of the substrate W. Alternatively, the acquisition of the outer diameter D of the roll 36 of the processing tape 2 by the tape outer diameter acquisition mechanism (in this embodiment, the measurement of the outer diameter D of the roll 36 of the processing tape 2 by the outer diameter measuring device 70) and the calculation of the rotary torque T by the rotary torque calculating section 72 may be performed each time processing of one substrate or a predetermined number of substrates is completed.

According to this embodiment, the substrate processing apparatus 1 can acquire the outer diameter D of the roll 36 of the processing tape 2 taken up on the tape take-up reel 22, and can calculate the rotary torque T for taking up the processing tape 2 with the predetermined appropriate tape tension F based on the acquired outer diameter D of the roll 36. As a result, the processing tape 2 can be taken up on the tape take-up reel 22 with the appropriate tape tension F even when the outer diameter D of the roll 36 of the processing tape 2 changes significantly.

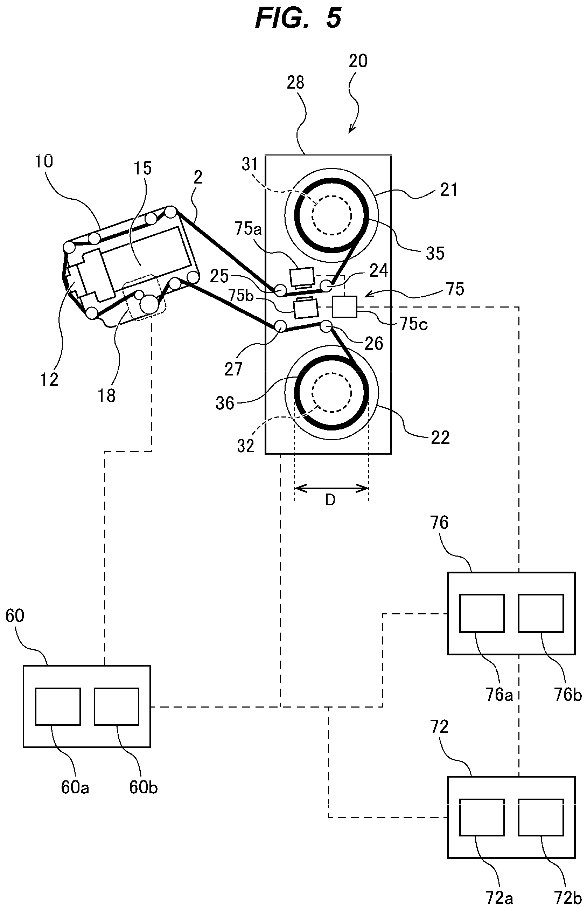

FIG. 5 is a schematic diagram showing another embodiment of the tape outer diameter acquisition mechanism. Configurations and operations of this embodiment, which will not be particularly described, are the same as those of the above-described embodiments, and duplicated descriptions will be omitted. The tape outer diameter acquisition mechanism of this embodiment includes, instead of the outer diameter measuring device 70, a thickness measuring device 75 configured to measure a thickness of the processing tape 2, and an outer diameter calculating section 76 configured to calculate the outer diameter D of the roll 36 based on the thickness of the processing tape 2 measured by the thickness measuring device 75 and an amount of use of the processing tape 2.

As shown in FIG. 5, the thickness measuring device 75 of this embodiment includes two distance measuring devices 75a and 75b disposed at both sides of the processing tape 2 in a thickness direction of the processing tape 2, and a signal processing section 75c electrically coupled to the distance measuring devices 75a and 75b. The two distance measuring devices 75a and 75b measure distances to surfaces of the processing tape 2, respectively. The signal processing section 75c is configured to detect the thickness of the processing tape 2 based on the distances to the surfaces of the processing tape 2 measured by the distance measuring devices 75a and 75b. Examples of each of the two distance measuring devices 75a and 75b include a non-contact type or contact type displacement sensor.

The two distance measuring devices 75a and 75b of this embodiment are disposed at both sides of the processing tape 2 extending between the tape feeding reel 21 and the processing head 10, while in one embodiment, the two distance measuring devices 75a and 75b may be disposed at both sides of the processing tape 2 extending between the processing head 10 and the tape take-up reel 22.

The specific configuration of the thickness measuring device 75 is not limited to this embodiment as long as the thickness of the processing tape 2 can be measured. For example, the thickness measuring device 75 may include a fixed wall having a support surface along which the processing tape 2 travels and one distance measuring device, and may be configured to measure a difference between a distance to the support surface of the fixed wall and a distance to the surface of the processing tape 2 on the support surface as the thickness of the processing tape 2.

The outer diameter calculating section 76 is electrically coupled to the thickness measuring device 75, and the thickness of the processing tape 2 measured by the thickness measuring device 75 is transmitted to the outer diameter calculating section 76. The outer diameter calculating section 76 is configured to calculate the outer diameter D of the roll 36 based on the thickness of the processing tape 2 measured by the thickness measuring device 75 and the amount of use of the processing tape 2. The amount of use of the processing tape 2 is calculated based on a rotation speed of a motor of a tape advancing device 18 and an advancing time of the processing tape 2. In this specification, the term "amount of use of the processing tape 2" refers to an accumulated value of the amount of use of the processing tape 2 from a point in time when use of an unused processing tape 2 is started.

The rotation speed of the motor of the tape advancing device 18 and the advancing time of the processing tape 2 are stored in the memory 60a of the operation controller 60. Specifically, the rotation speed of the motor of the tape advancing device 18 is stored in the memory 60a as a predetermined processing recipe. As the advancing time of the processing tape 2, an accumulated value of an operating time of the motor of the tape advancing device 18 from a point in time when the use of the unused processing tape 2 is started is measured and stored in the memory 60a. The outer diameter calculating section 76 is electrically coupled to the operation controller 60, and the rotation speed of the motor of the tape advancing device 18 and the advancing time of the processing tape 2 are transmitted to the outer diameter calculating section 76.

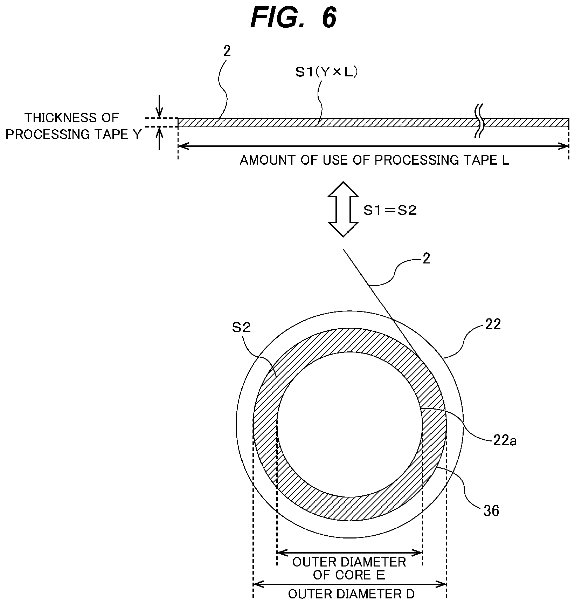

FIG. 6 is a diagram illustrating a method of calculating the outer diameter D of the roll 36 based on a thickness Y of the processing tape 2 measured by the outer diameter calculating section 76. A product S1 of the thickness Y of the processing tape 2 measured by the thickness measuring device 75 and an amount of use L of the processing tape is equal to an area S2 of the roll 36 of the processing tape 2 when viewed from an axial direction of the tape take-up reel 22.

The area S2 of the roll 36 of the processing tape 2 when viewed from the axial direction of the tape take-up reel 22 is represented by the following formula (2). $S 2 = π / 4 \left({D}^{2}-{E}^{2}\right)$ (2)

Here, D is the outer diameter of the roll 36, and E is an outer diameter of a core 22a of the tape take-up reel 22. Therefore, an equality of the following formula (3) is established, and the outer diameter D of the roll 36 is represented by the following formula (4). $Y \times L = π / 4 \left({D}^{2}-{E}^{2}\right)$ (3) $D = √ \left(Y\times L\times 4/π+{E}^{2}\right)$ (4)

The outer diameter calculating section 76 calculates the outer diameter D of the roll 36 from the thickness Y of the processing tape 2, the amount of use of the processing tape 2, and the outer diameter E of the core 22a of the tape take-up reel 22 using the above formula (4). The outer diameter E of the core 22a of the tape take-up reel 22 is stored in advance in a memory 76a of the outer diameter calculating section 76, which will be described later.

As shown in FIG. 5, in this embodiment, the rotary torque calculating section 72 is electrically coupled to the outer diameter calculating section 76, and the outer diameter D of the roll 36 of the processing tape 2 calculated by the outer diameter calculating section 76 is transmitted to the rotary torque calculating section 72. The rotary torque calculating section 72 calculates the rotary torque T from the outer diameter D of the roll 36 of the processing tape 2 calculated by the outer diameter calculating section 76 and the predetermined tape tension F using the above-described formula (1).

The outer diameter calculating section 76 includes at least one computer. The outer diameter calculating section 76 includes the memory 76a storing programs and the like therein, and a processor 76b configured to perform arithmetic operations according to instructions contained in the programs. The memory 76a includes a main memory, such as a random access memory (RAM), and an auxiliary memory, such as a hard disk drive (HDD) or a solid state drive (SSD). Examples of the processor 76b include a CPU (central processing unit) and a GPU (graphics processing unit). However, the specific configuration of the outer diameter calculating section 76 is not limited to these examples. In one embodiment, the outer diameter calculating section 76 may be configured integrally with the rotary torque calculating section 72 and/or the operation controller 60.

Measuring of the thickness of the processing tape 2 by the thickness measuring device 75 is performed at least every time a processing tape 2 having a different thickness is mounted to the tape feeding reel 21. Calculation of the outer diameter D of the roll 36 of the processing tape 2 by the outer diameter calculating section 76 and the calculation of the rotary torque T by the rotary torque calculating section 72 may be performed during the processing of the substrate W. Alternatively, the calculation of the outer diameter D of the roll 36 of the processing tape 2 by the outer diameter calculating section 76 and the calculation of the rotary torque T by the rotary torque calculating section 72 may be performed each time processing of one substrate or a predetermined number of substrates is completed.

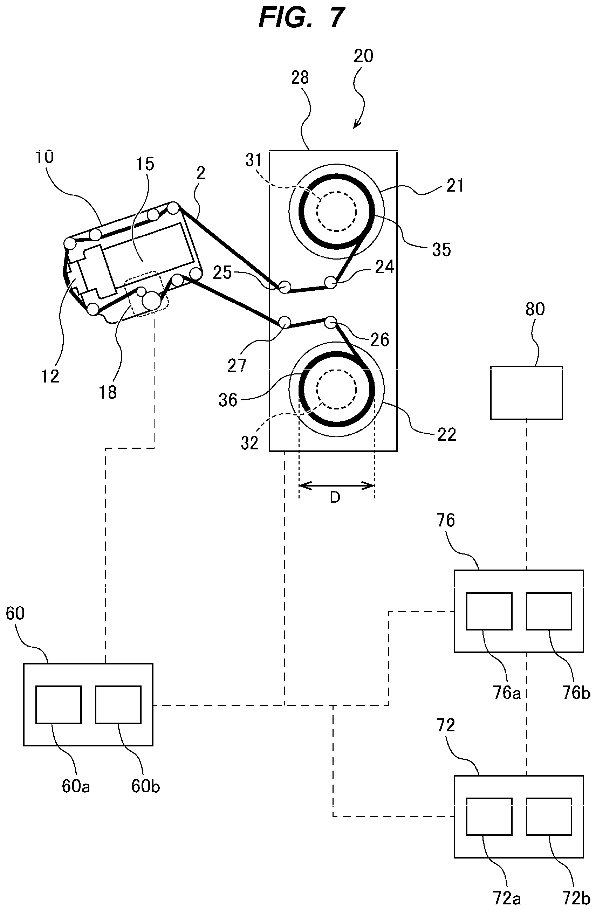

FIG. 7 is a schematic diagram showing still another embodiment of the tape outer diameter acquisition mechanism. Configurations and operations of this embodiment, which will not be particularly described, are the same as those of the embodiments described with reference to FIGS. 5 and 6, and duplicated descriptions will be omitted. In this embodiment, the outer diameter calculating section 76 is configured to calculate the outer diameter of the roll 36 based on a thickness of the processing tape 2 input via an input device 80 and the amount of use of the processing tape 2. A specific numerical value of the thickness of the processing tape 2 is available from specification data of the processing tape 2 provided by a manufacturer of the processing tape 2.

The input device 80 is electrically coupled to the outer diameter calculating section 76, and the thickness of the processing tape 2 input to the input device 80 is transmitted to the outer diameter calculating section 76. The input device 80 may be included in the substrate processing apparatus 1, or may be provided outside the substrate processing apparatus 1. The thickness of the processing tape 2 is input via the input device 80 at least every time a processing tape 2 having a different thickness is mounted to the tape feeding reel 21.

The outer diameter calculating section 76 calculates the outer diameter D of the roll 36 from the thickness of the processing tape 2 input via the input device 80, the amount of use of the processing tape 2, and the outer diameter E of the core 22a of the tape take-up reel 22 using the above-described formula (4). The outer diameter D of the roll 36 of the processing tape 2 calculated by the outer diameter calculating section 76 is transmitted to the rotary torque calculating section 72. The rotary torque calculating section 72 calculates the rotary torque T from the outer diameter D of the roll 36 of the processing tape 2 calculated by the outer diameter calculating section 76 and the predetermined tape tension F using the above-described formula (1).

The previous description of embodiments is provided to enable a person skilled in the art to make and use the present invention. Moreover, various modifications to these embodiments will be readily apparent to those skilled in the art, and the generic principles and specific examples defined herein may be applied to other embodiments. Therefore, the present invention is not intended to be limited to the embodiments described herein but is to be accorded the widest scope as defined by limitation of the claims.

### Industrial Applicability

The present invention is applicable to a substrate processing apparatus and a substrate processing method for processing a substrate, such as a wafer.

### Reference Signs List

- 1: substrate processing apparatus
- 2: processing tape
- 5: substrate holder
- 7: holding stage
- 7a: substrate holding surface
- 8: shaft
- 9: holding-stage driving mechanism
- 10: processing head
- 12: pressing member
- 15: air cylinder (actuator)
- 18: tape advancing mechanism
- 20: processing-tape feeding mechanism
- 21: tape feeding reel
- 22: tape take-up reel
- 24, 25, 26, 27: guide roller
- 28: reel base
- 31: feeding-reel rotating mechanism
- 32: take-up reel rotating mechanism
- 35, 36: roll
- 41: lower supply nozzle
- 42: upper supply nozzle
- 50: tilting mechanism
- 52: tilting arm
- 53: arm rotating device
- 60: operation controller
- 60a: memory
- 60b: processor
- 70: outer diameter measuring device
- 72: rotary torque calculating section
- 72a: memory
- 72b: processor
- 75: thickness measuring device
- 75a, 75b: distance measuring device
- 75c: signal processing section
- 76: outer diameter calculating section
- 76a: memory
- 76b: processor
- 80: input device

## Claims

1. A substrate processing apparatus comprising:
a substrate holder configured to hold and rotate a substrate;
a processing head configured to press a processing tape against the substrate to process the substrate;
a tape take-up reel configured to take up the processing tape that has been used in processing of the substrate;
a take-up reel rotating mechanism configured to rotate the tape take-up reel;
a tape outer diameter acquisition mechanism configured to acquire an outer diameter of a roll of the processing tape taken up on the tape take-up reel;
a rotary torque calculating section configured to calculate a rotary torque required for taking up the processing tape on the tape take-up reel with a predetermined tape tension based on the acquired outer diameter; and
an operation controller configured to control an operation of the take-up reel rotating mechanism,
wherein the operation controller is configured to instruct the take-up reel rotating mechanism to rotate the tape take-up reel with the calculated rotary torque.

2. The substrate processing apparatus according to claim 1, wherein
the tape outer diameter acquisition mechanism comprises an outer diameter measuring device configured to measure the outer diameter of the roll, and
the rotary torque calculating section is configured to calculate the rotary torque based on the measured outer diameter.

3. The substrate processing apparatus according to claim 1, wherein the tape outer diameter acquisition mechanism includes:
a thickness measuring device configured to measure a thickness of the processing tape; and
an outer diameter calculating section configured to calculate the outer diameter of the roll based on the measured thickness of the processing tape and an amount of use of the processing tape, and
the rotary torque calculating section is configured to calculate the rotary torque based on the calculated outer diameter.

4. The substrate processing apparatus according to claim 1, wherein
the tape outer diameter acquisition mechanism includes an outer diameter calculating section configured to calculate the outer diameter of the roll based on a thickness of the processing tape that has been input via an input device and an amount of use of the processing tape, and
the rotary torque calculating section is configured to calculate the rotary torque based on the calculated outer diameter.

5. The substrate processing apparatus according to any one of claims 1 to 4, wherein
the processing tape comprises a polishing tape having a polishing surface, and
the processing head comprises a polishing head configured to press the polishing surface against the substrate to polish the substrate.

6. A substrate processing method comprising:
holding and rotating a substrate, and pressing a processing tape against the substrate with a processing head to process the substrate;
rotating a tape take-up reel by a take-up reel rotating mechanism to take up the processing tape that has been used in processing of the substrate onto the tape take-up reel;
acquiring an outer diameter of a roll of the processing tape taken up on the tape take-up reel;
calculating a rotary torque required for taking up the processing tape on the tape take-up reel with a predetermined tape tension based on the acquired outer diameter; and
taking up the processing tape onto the tape take-up reel by rotating the tape take-up reel with the calculated rotary torque by the take-up reel rotating mechanism.

7. The substrate processing method according to claim 6, wherein
acquiring the outer diameter of the roll comprises measuring the outer diameter of the roll by an outer diameter measuring device, and
calculating the rotary torque comprises calculating the rotary torque based on the measured outer diameter.

8. The substrate processing method according to claim 6, wherein
acquiring the outer diameter of the roll comprises measuring a thickness of the processing tape by a thickness measuring device, and calculating the outer diameter of the roll based on the measured thickness of the processing tape and an amount of use of the processing tape, and
calculating the rotary torque comprises calculating the rotary torque based on the calculated outer diameter.

9. The substrate processing method according to claim 6, wherein
acquiring the outer diameter of the roll comprises calculating the outer diameter of the roll based on a thickness of the processing tape that has been input via an input device and an amount of use of the processing tape, and
calculating the rotary torque comprises calculating the rotary torque based on the calculated outer diameter.

10. The substrate processing method according to any one of claims 6 to 9, wherein processing the substrate comprises pressing a polishing surface of a polishing tape against the substrate with a polishing head to polish the substrate.
